(19) Europäisches Patentamt
European Patent Office
Office européen des brevets

(11) **EP 2 308 135 B1**

(12) **EUROPEAN PATENT SPECIFICATION**

(45) Date of publication and mention
of the grant of the patent:
**08.03.2017 Bulletin 2017/10**

(51) Int Cl.:
*H01R 13/03* (2006.01)    *H01R 12/58* (2011.01)
*H05K 3/30* (2006.01)

(21) Application number: **09781334.9**

(22) Date of filing: **31.07.2009**

(86) International application number:
**PCT/EP2009/059926**

(87) International publication number:
**WO 2010/015571 (11.02.2010 Gazette 2010/06)**

(54) **ELECTRICAL CONTACT PAIR**

ELEKTRISCHES KONTAKTPAAR

PAIRE DE CONTACTS ÉLECTRIQUES

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **04.08.2008 DE 102008036090**

(43) Date of publication of application:
**13.04.2011 Bulletin 2011/15**

(73) Proprietor: **TE Connectivity Germany GmbH
64625 Bensheim (DE)**

(72) Inventors:
• **SCHMIDT, Helge
67346 Speyer (DE)**
• **LEIDNER, Michael
67466 Lambrecht (DE)**

(74) Representative: **Grünecker Patent- und
Rechtsanwälte
PartG mbB
Leopoldstraße 4
80802 München (DE)**

(56) References cited:
WO-A-2007/082112    WO-A-2008/073159
DE-A1- 10 349 584    DE-A1-102006 057 143
GB-A- 411 383    US-A1- 2005 176 267
US-A1- 2005 255 725    US-A1- 2006 110 955

• "EPT EINPRESSTECHNIK TCOM PRESS" EPT
EINPRESSTECHNIK TCOM PRESS,
EPTELEKTRONISCHE PRAEZISIONSTEILE,
PEITING, DE, 1 August 1990 (1990-08-01), pages
1-24, XP000953833

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to an electrical contact pair, which comprises an electrically conductive contact element and a mating-contact element, which is likewise electrically conductive and which may be brought into electrical contact with the contact element at at least one contact point, wherein the contact element and/or the mating-contact element is/are equipped, at least at the contact point, with a tin-containing material, and a predetermined normal force is provided, by means of which the contact element and the mating-contact element are pressed together in operation.

The invention further relates to a method of manufacturing an electrical contact pair comprising an electrically conductive contact element and a likewise electrically conductive mating-contact element, which is adjacent to the contact element, and a method of contacting an electrically conductive contact element with an electrically conductive mating-contact element at at least one contact point, wherein, at the contact point, the surfaces of the contact element and/or the mating-contact element are provided with at least one curvature radius.

Electrically conductive contact elements may, for example, be disposed in plug-and-socket connectors that are plugged in and withdrawn multiple times. In addition, contact elements may be disposed on printed circuit boards, e.g. in the form of a through-hole to accommodate a press-fit contact, or in the form of an attached extension.

Document DE 10 2006 057143 A1 for example is directed to the optimization of contact surfaces between a press-fit pin and a socket accommodating a press-in portion of the pin in that the press-in portion is O-shaped such that it may be elastically compressed when being inserted into the socket. Further the disquisition "EPT EINPRESSTECHNIK TCOM PRESS" EPT EINPRESSTECHNIK TCOM PRESS; EPTELEKTRONISCHE PRAEZISIONSTEILE; PEITING; DE; 1 August 1990, pages 1-24, XP000953833 describes common shapes of press-in fit pins and respective sockets as well as certain requirements regarding their tolerances, coatings and handling.

Normally, contact elements are provided with a tin-containing protective layer intended to guarantee that the contact element satisfies electrical and mechanical requirements. A known disadvantage of tin surfaces is their tendency to form what are known as whiskers, i.e. needle-shaped tin monocrystals, which may be up to some 100 micrometres long. If whiskers are long enough to bridge the gap between the terminals of components, short-circuits and defects can occur.

Mechanical stresses within the tin layer, which initiate a relaxation process, are known to be a cause of whisker formation. As a result of the stresses, material transport of the tin atoms to positions of lower stress takes place via grain boundary diffusion, for which reason a displacement throughout as far as the surface causes the formation of needle-shaped crystals. After a storage time of seven weeks at ambient temperature, conventional tin surfaces already exhibit whiskers 30 $\mu$m to more than 100 $\mu$m in length.

In the past, it was possible to suppress the formation of whiskers on tin-containing surfaces by the addition of lead. Whereas protective layers were hitherto made from tin/lead alloys, the use of lead has now been restricted by the legislation of many regulators on the grounds of the known toxicity of lead and the increasing amount of dumped electronic waste. The change from tin/lead to lead-free tin layers that was necessary in this regard has intensified the problem of whisker formation, since, compared with tin/lead options, some of the favoured lead-free alternatives have a stronger tendency to whisker formation.

The miniaturisation of electronic components, which is accompanied by a reduction in conducting track and pin spacings, additionally increases the risk that, in the event of whisker formation, an electrical short circuit will take place between adjacent components. Consequently, the object of the invention is to increase the reliability of electrical, tin-containing contact pairs.

This object is achieved for an electrical contact pair of the kind specified above in that, at the contact point, the surfaces of the contact element and the mating-contact element exhibit a convex curvature and are provided with at least one curvature radius, and that the sum of the reciprocals of the curvature radii multiplied by the third root of the normal force acting between the contact element and the mating-contact element is less than 3.3, wherein for determination of the curvature radii (R1, R2, R3, R4), at every location of the contact point (C), the curvature radii (R1, R2, R3, R4) of the curves of intersection of the surface at the contact point (C) are considered with two normal planes perpendicular to one another established at this location. The unit of the normal force here is [N], and the unit of the curvature radii is [mm]:

$$\sqrt[3]{N} * \left( \frac{1}{R1} + \frac{1}{R2} + \frac{1}{R3} + \frac{1}{R4} \right) < 3.3$$

A configuration of contact elements of this kind offers the advantage that the stress gradient in the tin-containing material of the contact elements remains below a critical threshold value below which the growth of whiskers is distinctly reduced.

The "curvature radius" is the radius of an actual, measurable curvature. An area with a theoretically infinitely large curvature radius corresponds to a plane, and, according to the above definition, does not exhibit a curvature radius. Consequently, at the contact point at which a curvature radius is provided, at least one of the surfaces of the contact element and/or the mating-contact element is curved in at least one direction.

For determination of the curvature radii, at every location of the contact point, the curvature radii of the curves of intersection of the surface at the contact point are considered with the normal planes established at this location, i.e. the planes intersecting the surface perpendicularly.

To be used in particular for the above-mentioned condition are the maximum and the minimum curvature radii whose reciprocals define the principal curvatures of the surface at the contact point. The relevant curvature directions are located perpendicular relative to one another. In the case of an unrollable or cylindrical surface, only one curvature radius exists, whereas the second curvature radius is theoretically infinitely large and the corresponding principal curvature is equal to zero.

The curvature radii of the principal curvatures of the surface of a contact element or mating-contact element may also be of equal size at the contact point. This is the case, for instance, if the surface at the contact point is formed by a symmetrical end of an elliptical paraboloid or a spherical surface.

The curvature at any location of a contact point may in each case be described by two radius vectors located on normal planes running perpendicularly relative to one another. Here, negative values may also be assigned to the curvature radii.

The condition

$$\sqrt[3]{N} * \left( \frac{1}{R1} + \frac{1}{R2} + \frac{1}{R3} + \frac{1}{R4} \right) < 3.3 \quad \text{may}$$

preferably be fulfilled for any cutting planes through the adjoining portions of the surfaces of the contact element and the mating-contact element, i.e. through the contact point. In the case of a cutting plane deviating from the normal plane, the components of the normal force located on this cutting plane may, accordingly, be incorporated into the condition.

The pairing of a curved surface with a correspondingly curved one enables a reliable contact even when the contact element and mating-contact element are offset relative to one another, since, up to a specific angle of torsion, the support surfaces of the adjoining portions are not decreased.

The surface of the contact element and/or mating-contact element may, for example, assume a cylindrical form at the portions adjacent to the contact element and/or mating-contact element. In the case of a convex curvature of the surface, this forms at least one portion of the outer surface of a cylinder.

Alternatively, the surface of the contact element and/or mating-contact element may be spherical at the portions adjacent to the contact element and/or mating-contact element. In the case of a convex curvature of the surface, this forms at least one portion of the outer surface of a sphere.

A convex curvature of the surface at the contact point of a contact element, i.e. an outward arching, corresponds to a positive curvature radius. A planar surface, i.e. a lack of curvature of the surface of the contact element, is described theoretically by an infinite curvature radius. Conversely, a concave surface of the contact element, i.e. a curvature arching inwards, exhibits a negative curvature radius. If a concavely curved surface is paired with a convexly curved surface, the amount of the curvature radius of the concave curvature is advantageously greater than the amount of the curvature radius of the convex curvature.

In accordance with a further advantageous embodiment, the adjoining portions of the contact element and/or mating-contact element may be coated with pure tin. In this manner, the contact element and/or mating-contact element may be combined without problems with components that exhibit conventional, lead-containing tin alloys. Moreover, because of their hardness, coatings made of pure tin are relatively insensitive to mechanical stresses, and the soldering behaviour of pure tin is known.

The contact element and/or mating-contact element may be produced from sheet metal as a stamped part to enable the cost-effective mass production of the contact elements.

For an integrated, space-saving option, the contact element and/or mating-contact element may be disposed on a printed circuit board, e.g. in the form of a convex solder point or a through-hole.

For the above-mentioned method of manufacturing an electrical contact pair, the object is achieved in that the surfaces of the contact element and/or mating-contact element are provided with curvature radii at their adjoining portions, wherein the sum of the reciprocals of the curvature radii multiplied by the third root of the normal force provided between the contact element and mating-contact element is less than 3.3.

For the above-mentioned method of manufacturing an electrically conductive contact element with an electrically conductive mating-contact element, the object is achieved in that a normal force (N), compressing the contact element (2) and the mating-contact element (3) against one another and satisfying the following condition, is applied:

$$N < \left( \frac{3,3}{\frac{1}{R1} + \frac{1}{R2} + \frac{1}{R3} + \frac{1}{R4}} \right)^3$$

In this manner, the applied normal force N remains below a threshold that is critical for whisker formation.

The invention is explained below with reference to the drawings, by way of examples of different embodiments. Here, the embodiments described represent only possible configurations, which may be modified for the particular application. Individual features that are advantageous *per se* may be added or omitted in accordance with the above description of the advantageous configurations of any particular embodiment described.

The drawings show the following:

Fig. 1 is a schematic view of a first embodiment example of the invention;
Fig. 2 is a schematic view of a second embodiment example of the invention, which differs from the embodiment example shown in Fig. 1 in respect of the curvature radius of the mating-contact element;
Fig. 3 is a schematic view of a third embodiment example of the invention, which differs from the embodiment example shown in Fig. 1 in respect of the negative curvature radius of the mating-contact element;
Fig. 4 is a schematic front view of a press-fit contact;
Fig. 5 is a perspective view of the press-fit contact from Fig. 4;
Fig. 6 shows an electrical contact pair in accordance with the invention, comprising a printed circuit board and a press-fit contact in accordance with Fig. 4, wherein the sectional view shows the press-fit contact along the straight line A-A from Fig. 4;
Fig. 7 is a schematic sectional view of the electrical contact pair in accordance with Fig. 6 along the straight line VII-VII.

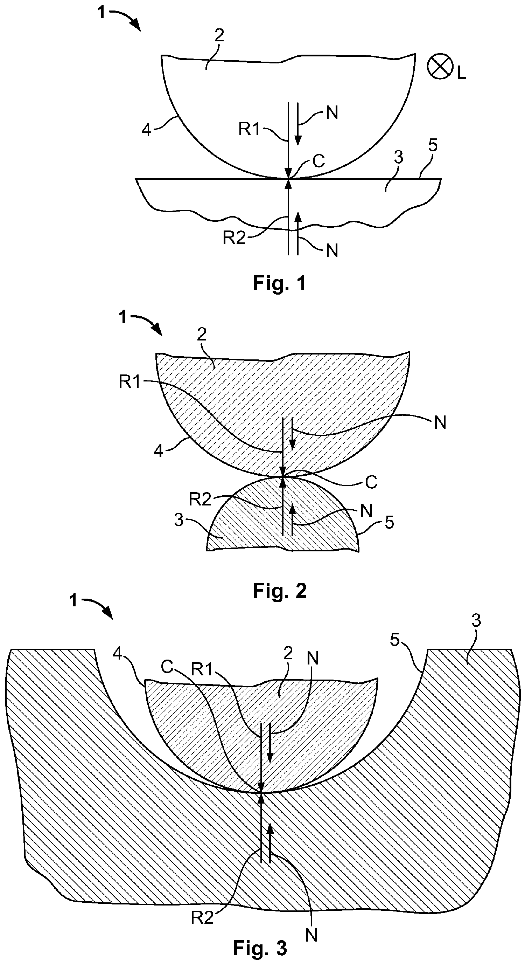

Fig. 1 shows an electrical contact pair 1, comprising an electrically conductive contact element 2 and, adjacent to the contact element 2, a mating-contact element 3, which is likewise electrically conductive. Only segments of the contact element 2 and the mating-contact element 3 are shown. The contact element 2 is formed by a contact pin, and the contact element 3 by a contact location on a printed circuit board, which contact location is connected to a conducting track.

Acting on the contact element 2 and the mating-contact element 3 is a normal force N, by means of which the contact element 2 and the mating-contact element 3 are pressed against one another at a contact point C. The contact element 2 exhibits a surface 4, which is provided with a curvature radius R1, including at the portion adjacent to the mating-contact element 3. Conversely, the surface 5 of the mating-contact element 3 does not exhibit a curvature radius, i.e. the curvature radius R2, which is shown here symbolically, is infinitely large. In the viewing direction, the surfaces 4, 5 are not curved, i.e. the surface 4 of the contact element 2 assumes a cylindrical shape at the portion adjacent to the mating-contact element 3, whereas the surface 5 assumes a planar shape at the portion adjacent to the contact element 2. The further radii R3, R4, which are not shown here and which describe the curvature of the adjoining portions of the surfaces 4, 5, are, like the radius R2, infinitely large.

Particularly in the case of base tin surfaces, the normal forces N applied between the contact element 2 and the mating-contact element 3 must be large enough to be capable of breaking open the oxide layer arising from the oxidation of the tin through plastic deformation of the surfaces 4, 5, since this is the only way of obtaining a reliable electrical contact. At the same time, the normal force N and the stress gradient arising below the adjoining portions of the surfaces 4, 5 must remain below a threshold critical for whisker formation. In order to maintain the whisker formation below a critical extent within the service life of the electrical contact pair 1, the condition that the sum of the reciprocals of the radii multiplied by the third root of the normal force N, or contact force N, is less than 3.3 is adhered to, wherein the contact pair exhibits only a curvature radius R1. The maximum occurring stress gradient of contact pair 1 thus remains below a value of 6.5 gigapascals per micrometer, so preventing whisker formation. The unit of the normal force here is [N] and the unit of the curvature radii is [mm].

Fig. 1 shows a plane of projection running through the contact point C and perpendicular to the longitudinal dimension of the cylinder formed by the surface 4. The cylindrical surface exhibits no curvature in the longitudinal direction L. Theoretically, the further curvature radii of the electrical contact pair, which are not present as design features, cannot be taken into account or regarded as infinitely large. The curvature radius R1 shown therefore fully describes the curvature of the surface of the contact element 2, i.e. the reciprocal of the radius R1 multiplied by the third root of the normal force N is less than 3.3.

If the radii in a first cutting plane are read off through contact point C, which forms a normal plane running through the contact point C obliquely relative to the longitudinal dimension of the cylindrical surface and thereby obliquely relative to the longitudinal direction L, two radii can be read off to describe the curvature of the surface of the contact element 2, wherein the second radius of the contact element 2 lies on a second cutting plane running through the contact point C orthogonally relative to the first cutting plane. The above condition is also fulfilled for any further cutting planes through the adjoining portions of the contact element and the mating-contact element.

Fig. 2 shows an electrical contact pair 1 with two spherical contact elements 2, 3. The spherical contact elements 2, 3 are shown in a sectional view, wherein the cutting plane of the sectional view runs through the contact point C and the centre points of the radii R1, R2. Since the contact elements 2, 3, by contrast with the cylindrical and planar contact elements 2, 3 in Fig. 1, exhibit radii in every cutting plane that intersects the centre points of the radii R1, R2, every radius is taken account of twice for the condition for reduction of whisker formation:

$$\sqrt[3]{N} * \left( \frac{2}{R1} + \frac{2}{R2} \right) < 3.3$$

The contact zones are thus configured in a manner such that the sum of the dual reciprocal of the radius R1 and the dual reciprocal of R2 multiplied by the third root of the normal force N is less than 3.3.

One of the contact elements 2, 3 or both contact elements 2, 3 may also comprise a partial surface area of an ellipsoid. Again, if one or both contact elements 2, 3 is configured as a partial surface area of an ellipsoid, then preferably, at any touching point between the contact elements 2, 3, the condition that the sum of the reciprocals of all curvature radii multiplied by the third root of the normal force N is less than 3.3 should be fulfilled. In the case of a three-dimensional curvature of the contact elements 2, 3, where, at least in the unstressed, no-load state, the contact point C does not contain a straight line at its portions adjacent in each case to the other contact element 2, 3, at least a second radius must in each case be taken into account in order to reduce whisker formation with the above-mentioned condition.

If a contact element 2, 3 takes the form of an ellipsoid, wherein the longitudinal dimension of the ellipsoid runs parallel to the adjoining portions of the surface 4, 5 of the contact element 2 and the mating-contact element 3, the radius located on the central plane running transversely relative to the longitudinal direction and the radius located on the central plane running along the longitudinal direction, for example, may be incorporated into the condition for the reduction of whisker formation.

Fig. 3 shows a sectional view of a third embodiment example of the contact pair 1 in accordance with the invention. A convex, i.e. outwardly curved contact element 2 is paired with a concave, i.e. inwardly curved contact element 3. In the viewing direction of the sectional view shown in Fig. 3, the surfaces 4, 5 of the contact elements 2, 3 do not exhibit a curvature radius, i.e. the surfaces 4, 5 are cylindrical in shape. The radius R2 of the concave, i.e. inwardly curved, surface 5 of the contact element 3 is negative, i.e. R2 is less than 0. Therefore:

$$\sqrt[3]{N} * \left( \frac{1}{R1} + \frac{1}{R2} \right) < 3.3$$

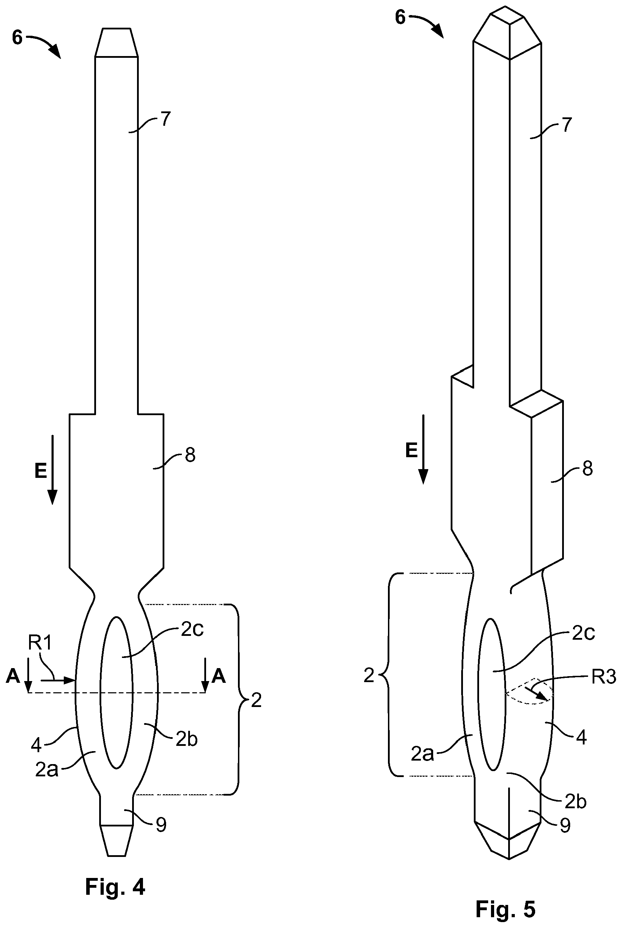

Fig. 4 shows a press-fit contact 6, which, in addition to a connecting portion 7, a fastening portion 8 and an inserting portion 9, is equipped with a press-fit portion 2, which serves as the contact element 2. Via the inserting portion 9, the press-fit contact 6 may be introduced into a through-hole in a printed circuit board. The contact element 2, which is disposed between the fastening portion 8 and the inserting portion 9, is equipped with two curved elements 2a, 2b, which enclose an elliptical slot 2c. When the press-fit contact 6 is pressed into a through-hole in a printed circuit board, the curved elements 2a, 2b of the contact element 2 are pressed together and deformed, so that the curved elements 2a, 2b press against the walls of the through-hole in the printed circuit board and produce a secure electrical connection.

The fastening portion 8 may, for example, be inserted, with further press-fit contacts 6, into appropriately designed fastening holes in a housing made of insulating material, so that the position of the press-fit contact 6 is stabilised relative to the printed circuit board.

Fig. 5 shows, in order to illustrate the press-fit contact shown in Fig. 4, a perspective view of the press-fit contact 6. The surface 4 of the contact element 2 is curved in two directions, i.e. the surface 4 is provided with a curvature radius R1, R3 both in the inserting direction E and also transversely relative to the inserting direction E.

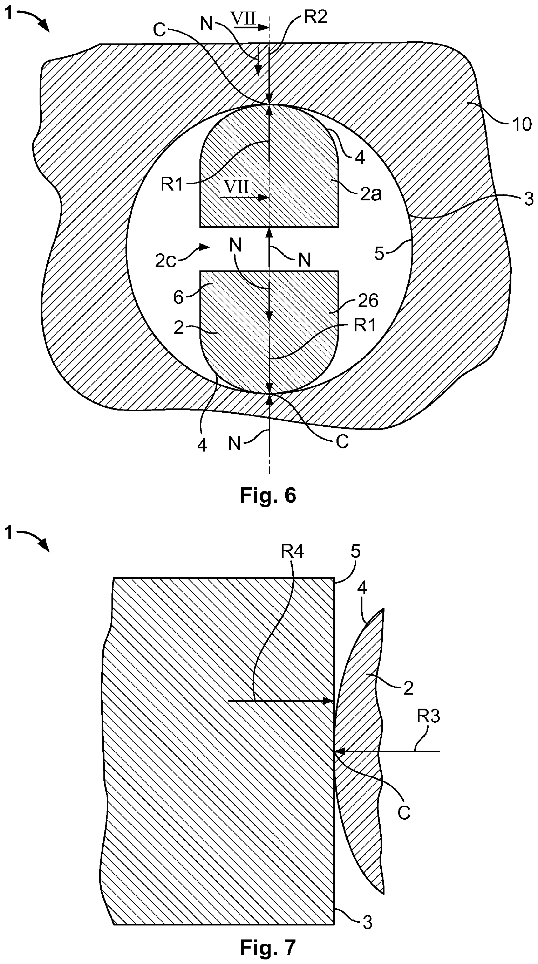

Fig. 6 shows a sectional view of a segment of a printed circuit board 10 with a through-hole 3, which forms the mating-contact element 3. Pressed into the through-hole 3 is a press-fit contact 6 in accordance with Fig. 4, Fig. 5. The press-fit contact 6 is shown in a sectional view corresponding to a section through location A-A in Fig. 4. The cutting plane in Fig. 6 corresponds to a normal plane through contact point C.

Owing to the elastic deformation of the curved elements 2a, 2b, normal forces N act between the through-hole 3 and the curved elements 2a, 2b at the adjoining portions in each case, which normal forces produce the electrical contact between the press-fit contact 2 and the printed circuit board 10. The contact pair 1 shown in Fig. 6 again exhibits curvature radii in accordance with claim 1, wherein the radius R2 of the through-hole 3 is negative by virtue of its concave, i.e. inwardly curved, configuration.

Fig. 7 shows a sectional view along the straight line VII-VII from Fig. 6. The cutting plane in Fig. 7 again corresponds to a normal plane through the contact point C. In this plane, the surface 4 of the contact element 2 exhibits a curvature radius R3, whereas the surface 5 of the contact element 3 runs in a straight line or is provided with a theoretically infinitely large curvature radius R4. The radii R3 and R4 of this second normal plane are also taken into account in the configuration of contact pair 1, so that:

$$\sqrt[3]{N} * \left( \frac{1}{R1} + \frac{1}{R2} + \frac{1}{R3} + \frac{1}{R4} \right) < 3.3$$

**Claims**

1. Electrical contact pair (1), comprising an electrically conductive contact element (2) and a mating-contact element (3) which is likewise electrically conductive and which may be brought into electrical contact with the contact element (2) at at least one contact point (C), wherein the contact element (2) and/or the mating-contact element (3) is/are equipped, at least at the contact point (C), with a tin-containing material, and a predetermined normal force (N) is provided, by means of which the contact element (2) and the mating-contact element (3) are compressed together in operation, **characterised in that**, at the contact point (C), the surfaces of the contact element (2) and the mating-contact element (3) exhibit a convex curvature and are provided with at least one curvature radius (R1, R2, R3, R4), and that the sum of the reciprocals of the curvature radii (R1, R2, R3, R4) multiplied by the third root of the normal force (N) acting between the contact element (2) and the mating-contact element (3) is less than 3.3, wherein for determination of the curvature radii (R1, R2, R3, R4), at every location of the contact point (C), the curvature radii (R1, R2, R3, R4) of the curves of intersection of the surface at the contact point (C) are considered with two normal planes perpendicular relative to one another established at this location.

2. Electrical contact pair (1) according to claim 1, **characterised in that** the curvature radii (R1, R2, R3, R4) are located in any cutting planes through the contact point (C).

3. Electrical contact pair (1) according to claim 1 or 2, **characterised in that** the surface of the contact element (2) and/or the mating-contact element (3) assumes a cylindrical shape at the portions adjacent to the contact point (C).

4. Electrical contact pair (1) according to any of claims 1 to 3, **characterised in that** the surface of the contact element (2) and/or the mating-contact element (3) is spherical in shape at the portions adjacent to the contact element or mating-contact element (2, 3).

5. Electrical contact pair (1) according to any of claims 1 to 4, **characterised in that** the adjoining portions of the contact element (2) and/or mating-contact element (3) are coated with pure tin.

6. Method of contacting an electrically conductive contact element (2) with an electrically conductive mating-contact element (3) at at least one contact point (C), wherein the contact element (2) and/ or the mating-contact element (3) is/are equipped, at least at the contact point (C), with a tin-containing material, and a predetermined normal force (N) is provided, by means of which the contact element (2) and the mating-contact element (3) are compressed together in operation, **characterised in that**, at the contact point (C), the surfaces of the contact element (2) and the mating-contact element (3) exhibit a convex curvature and are provided with at least one curvature radius (R1, R2, R3, R4), and the sum of the reciprocals of the curvature radii (R1, R2, R3, R4) multiplied by the third root of the normal force (N) acting between the contact element (2) and the mating-contact element (3) is less than 3.3, wherein for determination of the curvature radii (R1, R2, R3, R4), at every location of the contact point (C), the curvature radii (R1, R2, R3, R4) of the curves of intersection of the surface at the contact point (C) are considered with two normal planes perpendicular relative to one another established at this location.

**Patentansprüche**

1. Elektrisches Kontaktpaar (1), das ein elektrisch leitendes Kontaktelement (2) und ein Gegenkontaktelement (3) umfasst, das ebenfalls elektrisch leitend ist und das mit dem Kontaktelement (2) an wenigstens einem Kontaktpunkt (C) in elektrischen Kontakt gebracht werden kann, wobei das Kontaktelement (2) und/oder das Gegenkontaktelement (3) wenigstens an dem Kontaktpunkt (C) mit einem Zinn enthaltenden Material ausgestattet ist/sind, wobei eine vorgegebene Normalkraft (N) bereitgestellt wird, durch die das Kontaktelement (2) und das Gegenkontaktelement (3) im Betrieb zusammengepresst werden, **dadurch gekennzeichnet, dass** an dem Kontaktpunkt (C) die Oberflächen des Kontaktelements (2) und des Gegenkontaktelements (3) eine konvexe Krümmung aufweisen und mit wenigstens einem Krümmungsradius (R1, R2, R3, R4) bereitgestellt werden und dass die Summe der Kehrwerte der Krümmungsradien (R1, R2, R3, R4) multipliziert mit der Kubikwurzel der Normalkraft (N), die zwischen dem Kontaktelement (2) und dem Gegenkontaktelement (3) wirkt, geringer als 3,3 ist, wobei für die Bestimmung der Krümmungsradien (R1, R2, R3, R4) an jeder Stelle des Kontaktpunktes (C) die Krümmungsradien (R1, R2, R3, R4) der Schnittkurven der Oberfläche an dem Kontaktpunkt (C) mit zwei normalen Ebenen rechtwinklig relativ zueinander angesehen werden, die an dieser Stelle errichtet werden.

2. Elektrisches Kontaktpaar (1) nach Anspruch 1, **dadurch gekennzeichnet, dass** sich die Kurvenradien (R1, R2, R3, R4) in allen Schnittebenen durch den Kontaktpunkt (C) befinden.

3. Elektrisches Kontaktpaar (1) nach Anspruch 1 oder 2, **dadurch gekennzeichnet, dass** die Oberfläche des Kontaktelements (2) und/oder des Gegenkontaktelements (3) eine zylindrische Form an den Teilen angrenzend an den Kontaktpunkt (C) annehmen.

4. Elektrisches Kontaktpaar (1) nach einem der Ansprüche 1 bis 3, **dadurch gekennzeichnet, dass** die Oberfläche des Kontaktelements (2) und/oder des Gegenkontaktelements (3) an den Teilen angrenzend an das Kontaktelement oder an das Gegenkontaktelement (2, 3) in der Form kugelförmig sind.

5. Elektrisches Kontaktpaar (1) nach einem der Ansprüche 1 bis 4, **dadurch gekennzeichnet, dass** die angrenzenden Teile des Kontaktelements (2) und/oder des Gegenkontaktelements (3) mit reinem Zinn beschichtet sind.

6. Verfahren zur Kontaktherstellung eines elektrisch leitenden Kontaktelements (2) mit einem elektrisch leitenden Gegenkontaktelement (3) an wenigstens einem Kontaktpunkt (C), wobei das Kontaktelement (2) und/oder das Gegenkontaktelement (3) wenigstens an dem Kontaktpunkt (C) mit einem Zinn enthaltenden Material ausgestattet ist/sind, wobei eine vorgegebene Normalkraft (N) bereitgestellt wird, durch die das Kontaktelement (2) und das Gegenkontaktelement (3) im Betrieb zusammengepresst werden, **dadurch gekennzeichnet, dass** an dem Kontaktpunkt (C) die Oberflächen des Kontaktelements (2) und des Gegenkontaktelements (3) eine konvexe Krümmung aufweisen und mit wenigstens einem Krümmungsradius (R1, R2, R3, R4) bereitgestellt werden und dass die Summe der Kehrwerte der Krümmungsradien (R1, R2, R3, R4) multipliziert mit der Kubikwurzel der Normalkraft (N), die zwischen dem Kontaktelement (2) und dem Gegenkontaktelement (3) wirkt, geringer als 3,3 ist, wobei für die Bestimmung der Krümmungsradien (R1, R2, R3, R4) an jeder Stelle des Kontaktpunktes (C) die Krümmungsradien (R1, R2, R3, R4) der Schnittkurven der Oberfläche an dem Kontaktpunkt (C) mit zwei normalen Ebenen rechtwinklig relativ zueinander angesehen werden, die an dieser Stelle errichtet werden.

**Revendications**

1. Paire de contacts électriques (1) comprenant un élément formant contact électriquement conducteur (2) et un élément formant contact conjugué (3) qui est de même électriquement conducteur et qui peut être mis en contact électrique avec l'élément de contact (2) au niveau d'au moins un point de contact (C), l'élément de contact (2) et/ou l'élément de contact conjugué (3) étant pourvus, au moins au niveau du point de contact (C), d'un matériau contenant de l'étain, et une force normale (N) prédéterminée est procurée, au moyen de laquelle l'élément de contact (2) et l'élément de contact conjugué (3) sont comprimés ensemble en service, **caractérisée en ce que**, au niveau du point de contact (C), les surfaces de l'élément de contact (2) et de l'élément de contact conjugué (3) présentent une courbure convexe et sont dotés d'au moins un rayon de courbure (R1, R2, R3, R4), et **en ce que** la somme des réciproques des rayons de courbure (R1, R2, R3, R4) multipliée par la racine cubique de la force normale (N) agissant entre l'élément de contact (2) et l'élément de contact conjugué (3) est inférieure à 3,3, où, en ce qui concerne la détermination des rayons de courbure (R1, R2, R3, R4), à chaque emplacement du point de contact (C), les rayons de courbure (R1, R2, R3, R4) des courbes d'intersection de la surface au niveau du point de contact (C) sont considérés avec deux plans normaux perpendiculaires l'un par rapport à l'autre établis à cet emplacement.

2. Paire de contacts électriques (1) selon la revendication 1, **caractérisée en ce que** les rayons de courbure (R1, R2, R3, R4) sont situés dans tout plan de coupe par l'intermédiaire du point de contact (C).

3. Paire de contacts électriques (1) selon la revendication 1 ou la revendication 2, **caractérisée en ce que** la surface de l'élément de contact (2) et/ou de l'élément de contact conjugué (3) présente une forme cylindrique au niveau des parties adjacentes au point de contact (C).

4. Paire de contacts électriques (1) selon l'une quelconque des revendications 1 à 3, **caractérisée en ce que** la surface de l'élément de contact (2) et/ou de l'élément de contact conjugué (3) est de forme sphérique au niveau des parties adjacentes à l'élément de contact ou à l'élément de contact conjugué (2, 3).

5. Paire de contacts électriques (1) selon l'une quelconque des revendications 1 à 4, **caractérisée en ce que** les parties jointives de l'élément de contact (2) et/ou de l'élément de contact conjugué (3) sont revêtues d'étain pur.

6. Procédé de mise en contact d'un élément formant contact électriquement conducteur (2) avec un élément formant contact conjugué (3) au niveau d'au moins un point de contact (C), l'élément de contact (2) et/ou l'élément de contact conjugué (3) étant pourvus, au moins au niveau du point de contact (C), d'un matériau contenant de l'étain, et une force normale (N) prédéterminée est procurée, au moyen de laquelle l'élément de contact (2) et l'élément de contact conjugué (3) sont comprimés ensemble en service, **caractérisée en ce que**, au niveau du point de contact (C), les surfaces de l'élément de contact (2) et de l'élément de contact conjugué (3) présentent une courbure convexe et sont dotés d'au moins un rayon de courbure (R1, R2, R3, R4), et **en ce que** la somme des réciproques des rayons de courbure (R1, R2, R3, R4) multipliée par la racine cubique de la force normale (N) agissant entre l'élément de contact (2) et l'élément de contact conjugué (3) est inférieure à 3,3, dans lequel, en ce qui concerne la détermination des rayons de courbure (R1, R2, R3, R4), à chaque emplacement du point de contact (C), les rayons de courbure (R1, R2, R3, R4) des courbes d'intersection de la surface au niveau du point de contact (C) sont considérés avec deux plans normaux perpendiculaires l'un par rapport à l'autre établis à cet emplacement.

**Fig. 1**

**Fig. 2**

**Fig. 3**

**Fig. 4**

**Fig. 5**

**Fig. 6**

**Fig. 7**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102006057143 A1

**Non-patent literature cited in the description**

- EPT EINPRESSTECHNIK TCOM PRESS. EPT ELEKTRONISCHE PRAEZISIONSTEILE. EPT EINPRESSTECHNIK TCOM PRESS, 01 August 1990, 1-24